# EUROPEAN PATENT SPECIFICATION

(11) **EP 4 578 018 B1**
(45) Date of publication and mention of the grant of the patent: **07.10.2026**
(21) Application number: 23765353.0
(22) Date of filing: 14.08.2023
(51) Int. Cl.: G11C 17/16, G11C 17/18, G11C 7/06, H10W 20/49

(54) **ULTRA-LOW POWER, HIGH SPEED POLY FUSE EPROM**
HOCHGESCHWINDIGKEITS-POLYSICHERUNGS-EPROM MIT EXTREM NIEDRIGER LEISTUNG
EPROM À PLUSIEURS FUSIBLES, À PUISSANCE ULTRA-FAIBLE ET À GRANDE VITESSE

(30) Priority: 24.08.2022 US 202263400501 P; 27.02.2023 US 202318114449
(43) Date of publication of application: 02.07.2025
(73) Proprietor: Texas Instruments Incorporated, Dallas, Texas 75265-5474 (US)
(72) Inventor: CHANDRASHEKARA, Likhita, Bangalore 560093 (IN); DIDHE, Yash, Bangalore 560093 (IN); CHAUHAN, Rajat, Bangalore 560093 (IN); RAJAGOPAL, Devraj, Bangalore 56009 (IN)
(74) Representative: Zeller, Andreas
(86) International application number: PCT/US2023/030146
(87) International publication number: WO 2024/044056

(56) References cited:
- US-A1- 2009 002 119
- US-A1- 2009 002 119
- US-A1- 2009 219 746
- US-A1- 2009 219 746
- US-B1- 7 339 848
- US-B1- 7 339 848
- US-B1- 8 441 266
- US-B1- 8 441 266

## Description

This disclosure relates to the field of semiconductor devices, and more particularly, but not exclusively, to memory cells.

### BACKGROUND

Electrically-programmable memory cells enjoy uses in many contexts, including trimming various analog circuits to account for manufacturing variation. Such cells consume valuable space on an IC die, and may contribute to reliability issues. US 8,441,266 relates to a sensing circuit. US 2009/219746 discloses a circuit arrangement comprising a non-volatile memory cell and method.

### SUMMARY

The invention is defined by the features of independent claims. Preferred embodiments are set out in the dependent claims.

### OF THE DRAWINGS

FIG. 1 illustrates a fuse memory cell circuit according to the disclosure;
FIG. 2 illustrates a fuse memory cell circuit such as that shown in FIG. 1 with additional components;
FIG. 3 presents a timing diagram illustrating aspects of operation of the fused memory cell circuits of FIGs. 1 and 2.
FIG. 4 illustrates a fuse memory cell circuit such as that shown in FIG. 2 including current sinks connected to a fuse and a reference resistor;
FIG. 5 illustrates an implementation of a fused memory cell circuit such as that shown in FIG. 2 on a semiconductor die;
FIG. 6 illustrates an array of fused memory cell circuits such as that shown in FIG. 5; and
FIG. 7 illustrates a method of forming an integrated circuit according to various examples.

### DETAILED DESCRIPTION OF EXAMPLE EMBODIMENTS

The present disclosure is described with reference to the attached figures. The figures may not be drawn to scale and they are provided merely to illustrate the disclosure. Several aspects of the disclosure are described below with reference to example applications for illustration, in which like features correspond to like reference numbers. It should be understood that numerous specific details, relationships, and methods are set forth to provide an understanding of the disclosure. The present disclosure is not limited by the illustrated ordering of acts or events, as some acts may occur in different orders and/or concurrently with other acts or events. Furthermore, not all illustrated acts or events may be required to implement a methodology in accordance with the present disclosure.

This application discloses various methods and devices that may be beneficially applied to integrated circuits (ICs), such as those including electrically programmable fuse memory cells, e.g. by reducing static current and providing a short read time. While such embodiments may be expected to provide improvements such as reducing overall IC power requirements, no particular result is a requirement of the described invention(s) unless explicitly recited in a particular claim.

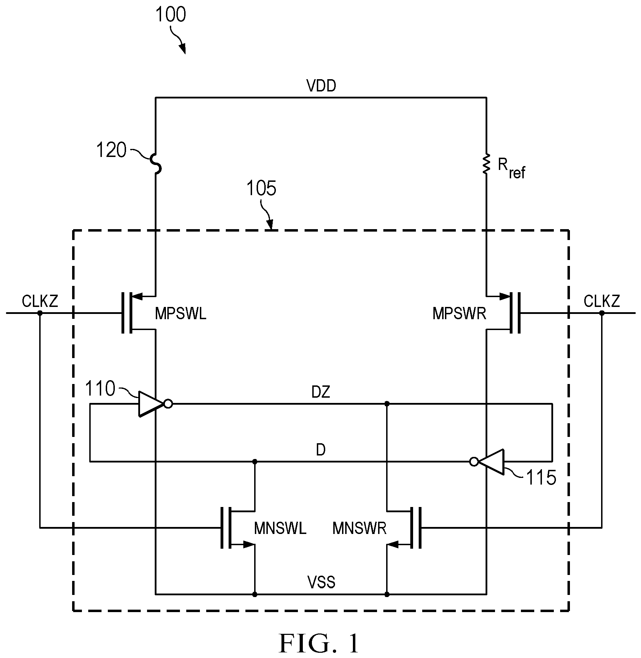

Referring to FIG. 1, an electrically programable memory cell 100 is schematically illustrated. The memory cell 100 includes a sense amplifier 105 that includes a latch having a first inverter 110 and a second inverter 115. The inverters 110, 115 are cross-coupled in a manner that may store a bit-value in a quasi-static fashion. For convenience of description the output of the inverter 115 is designated as the "D node", and the output of the inverter 110 is designated as the inverse of the D node, or the "DZ node". The inverters 110, 115 are configured with other components of the memory cell 100 in left-right symmetric fashion. A "left-hand leg" of the memory cell 100 includes a PMOS transistor MPSWL with a source connected to a fuse 120 and a drain connected to a positive power terminal of the inverter 110. An NMOS transistor MNSWL has a drain connected to the D node and a source connected to a lower power rail designated VSS. Similarly, a "right-hand leg" includes a PMOS transistor MPSWR with a source connected to R_{ref} and a drain connected to a positive power terminal of the inverter 115. An NMOS transistor MNSWR has a drain connected to the DZ node and a source connected to VSS. During the positive phase of a CLKZ signal, the transistor MNSWL conductively connects the D node to VSS, and the transistor MNSWR conductively connects the DZ node to the VSS. During the negative phase of CLKZ, the transistor MPSWL conductively connects the positive power terminal of the inverter 110 to the fuse 120, and the transistor MPSWR conductively connects the positive power terminal of the inverter 115 to R_{ref}.

Negative power terminals of the inverters 110 and 115 are connected to the lower power rail in an unswitched fashion. Conversely, the inverter 110 is connected to an upper power rail, designated VDD, via the transistor MPSWL and the fuse 120, and the inverter 115 is connected to VDD via the transistor MPSWR and V_{ref}. The transistor MPSWL is directly connected to the first terminal of a fuse 120, and the MPSWR is directly connected to a first terminal of the reference resistor R_{ref}. A second terminal of the fuse 120 and a second terminal of R_{ref} are both connected to VDD.

The fuse 120 may be formed from any material that can be patterned to form a current path that may be selectively broken to produce a high-resistance state between the first and second fuse terminals. In various examples, and as described without implied limitation, the fuse 120 is formed from polysilicon. In various examples the fuse 120 has an "hourglass" or "dog bone" shape, in which wide terminal portions with relatively low resistance are initially connected by a narrow conductive path having an initial resistance. A sufficiently high current, producing a commensurately high current density, may damage a portion of the narrow conductive path resulting in a programmed resistance that is typically much larger than the initial resistance. For example, the fuse 120 may have a resistance R_{fuse} that has an initial, unprogrammed value of about 100 Ω, and a programmed value greater than 50 kΩ.

The reference resistor R_{ref} has a resistance that is greater than the unprogrammed resistance of the fuse 120 and less than the programmed resistance of the fuse 120. In one example, R_{ref} may be about one-half of the minimum expected value of R_{fuse} in the programmed state, for example 25 kΩ. In various examples, R_{ref} is significantly greater, e.g. >100x, than the unprogrammed resistance of the fuse 120.

In a non-read, or quiescent state, CLK is unasserted, resulting in MNSWL and MNSWR being switched on and pulling the D and DZ nodes to VSS. In a read state CLK is asserted, allowing D and DZ to settle to an active state. This condition results in insignificant power consumption by the memory cell 100. The value of the D node in the active state is determined by the relative resistance of R_{fuse} and R_{ref}. As described in greater detail below, if R_{fuse}< R_{ref}, e.g. in an unprogrammed state, the D node will settle to an unasserted value, e.g. a digital "0" or FALSE state, and the DZ node will settle to an asserted value, e.g. a digital "1" or TRUE state. Conversely, if R_{fuse}> R_{ref}, e.g. in an programmed state, the D node will settle to a TRUE state, and the DZ node will settle to a FALSE state. After settling into the active state, insignificant power is consumed by the memory cell 100.

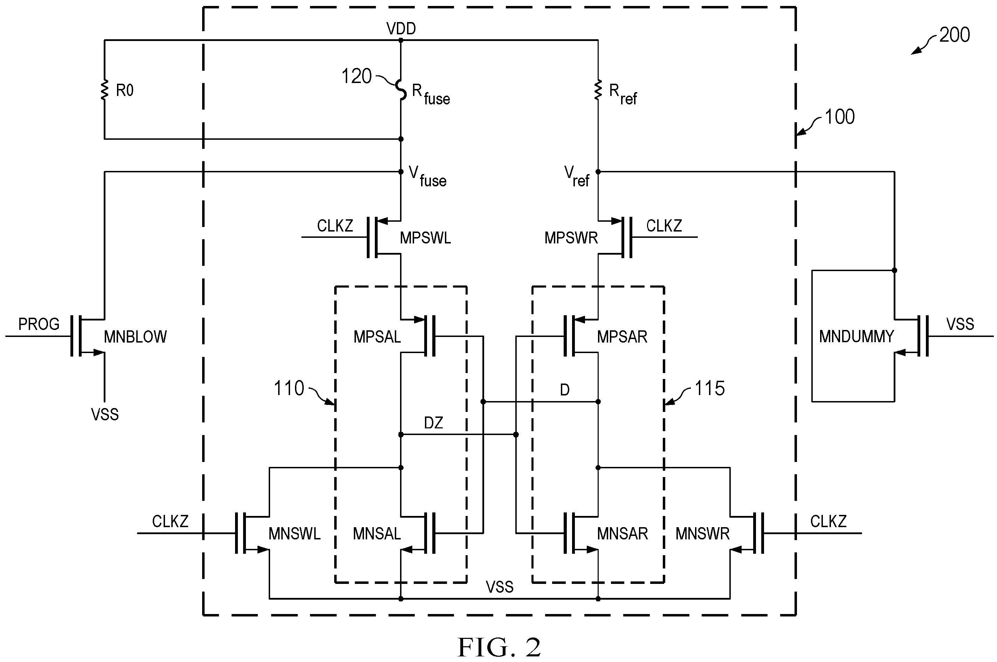

FIG. 2 illustrates an example of a memory cell 200 in which the inverter 110 is implemented by a PMOS transistor MPSAL and an NMOS transistor MNSAL., and the inverter 115 is implemented by a PMOS transistor MPSAR and an NMOS transistor MNSAR. MPSAL and MNSAL are connected at a first output node that serves as the DZ node, and MPSAR and MNSAR are connected at a second output node that serves as the D node. Gate terminals of MPSAL and MNSAL are connected at a first input node connected to the D node, and gate terminals of MPSAR and MNSAR are connected at a second input node connected to the DZ node

As described previously, in a quiescent state (e.g. CLK=FALSE and CLKZ=TRUE) the transistors MNSWL and MNSWR are switched on, holding the D and DZ node values to VSS. In a read state (e.g. CLK=TRUE and CLKZ=FALSE), MNSWL and MNSWR are switched off and MPSWL and MPSWR are switched on. Immediately following the transition from the quiescent state to the active state, MPSAL and MPSAR are switched on and MNSAL and MNSAR are switched off due to the immediately preceding VSS state of the D and DZ nodes. The state at which the D and DZ nodes settle is determined by a race between the left-hand leg and the right-hand leg. The combined resistance and capacitance of the components in the left-hand leg result in a first time constant *τ_{L}* that determines the rate at which the voltage of the DZ node increases from VSS, and the combined resistance and capacitance of the components in the right-hand leg result in a second time constant *τ_{R}* that determines the rate at which the voltage of the D node increases from VSS. If *τ_{L}*<*τ_{R}* (unprogrammed state) DZ increases to a value sufficient to switch on MNSAR before D can increase to a value sufficient to switch on MNSAL, and the D and DZ nodes respectively settle to values of 0 and 1. On the other hand, if *τ_{L}>τ_{R}* (programmed state) D increases to a value sufficient to switch on MNSAL before DZ can increase to a value sufficient to switch on MNSAR, and the nodes D and DZ nodes respectively settle to values of 1 and 0.

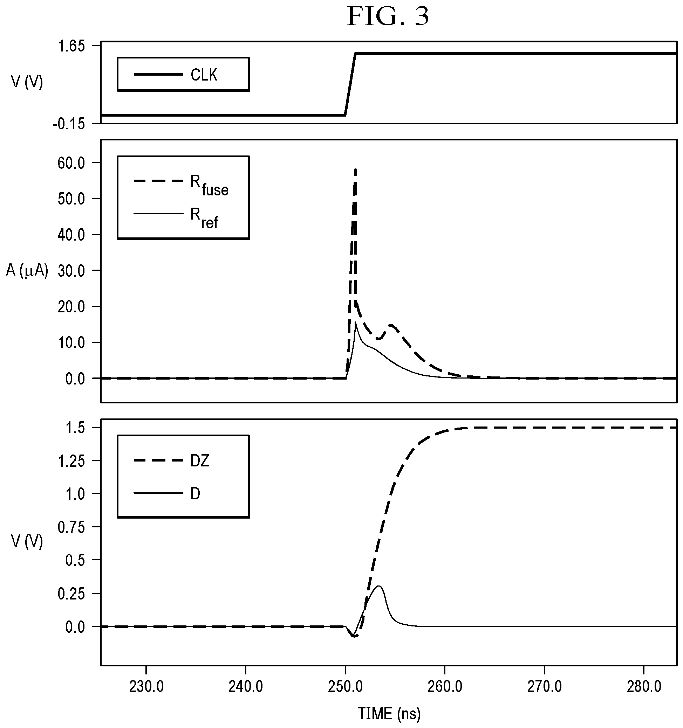

Read operation is exemplified in FIG. 3, which shows simulated voltage and current values versus time t at various nodes of the memory cell 100 for the example of R_{fuse}=100 Ω (unprogrammed) and R_{ef}=25 kΩ. Prior to t=250 ns, CLK is unasserted (CLKZ is asserted), the current through the fuse 120 and R_{ref} are both zero, and the voltage at the D and DZ nodes is zero. CLK is asserted at *t*=250 ns, which results in a peak current of about 55 µA through the fuse 120 and a peak current of about 15 µA through the reference resistor R_{ref}. Initially the voltage at the D and DZ nodes increases about a same rate, but within 2-3 ns the voltage at the DZ node overtakes the voltage at the D node and the state of the memory cell 100 settles in the unprogrammed state. The current through the fuse 120 and R_{ref} return to zero when the state of the memory cell 100 settles. Thus the static current is seen to be very low, e.g. ≤ 75 nA, and the read time is very short, e.g. < 17 ns.

It is noted the voltages shown in FIG. 3 are only one example provided without implied limitation. In this example the circuit uses 5 V transistors and is operating between 0.9 V and 5.5 V, where 0.9 V is determined by the threshold voltage of the transistors and 5.5 V is determined as a reliable operating limit of a 5 V transistor. The voltage range of operation can be extended, e.g. by using low threshold-voltage (LVT) devices in some other examples.

Returning to FIG. 2, in various examples the transistors MPSWL and MPSWR are matched, e.g. have about a same (within manufacturing tolerance) resistance and capacitance. For example, each of these transistors may have a same gate length (or channel length) and a same gate width (or drive current). Similarly, in various examples MPSAL and MPSAR are matched, and MNSAL and MNSAR are matched. In some examples, all of the transistors in the memory cell 100 are closely spaced on a semiconductor substrate such that manufacturing variation is negligible between matched transistors.

Other components of the memory cell 200 include transistors MNBLOW and MNDUMMY. In a programming operation, MNBLOW is switched by an asserted PROG signal and acts to sink current through the fuse 120 if in the unprogrammed state. The drive current capacity of MNBLOW is selected to support a sufficient current to damage the narrow conductive path of the fuse 120, increasing the resistance from the unprogrammed value to the programmed value. The connection of MNBLOW to the fuse 120 terminal may increase the capacitance associated with the left-hand leg of the memory cell 100, and without compensation result in altering the timing of operation during the previously described settling period. In some examples, the MNDUMMY is a dummy transistor matched to the MNBLOW transistor to provide such compensation. In such examples the source and drain of MNDUMMY are connected so this transistor provides no active electrical function.

In an additional example, a shunt resistor R0 is connected to the terminals of the fuse 120 to inhibit growth of a low-resistance path between the terminals after the fuse 120 is blown. Such regrowth may result from the electric field between the terminals in the absence of the shunt resistor. In various examples R0 has a resistance at least twice that of a predetermined minimum resistance of the fuse 120 in the programmed state. Space permitting, it may be desirable that R0 has a resistance at least ten times that of the predetermined minimum resistance of the fuse 120 in the programmed state, e.g. about 500 kΩ.

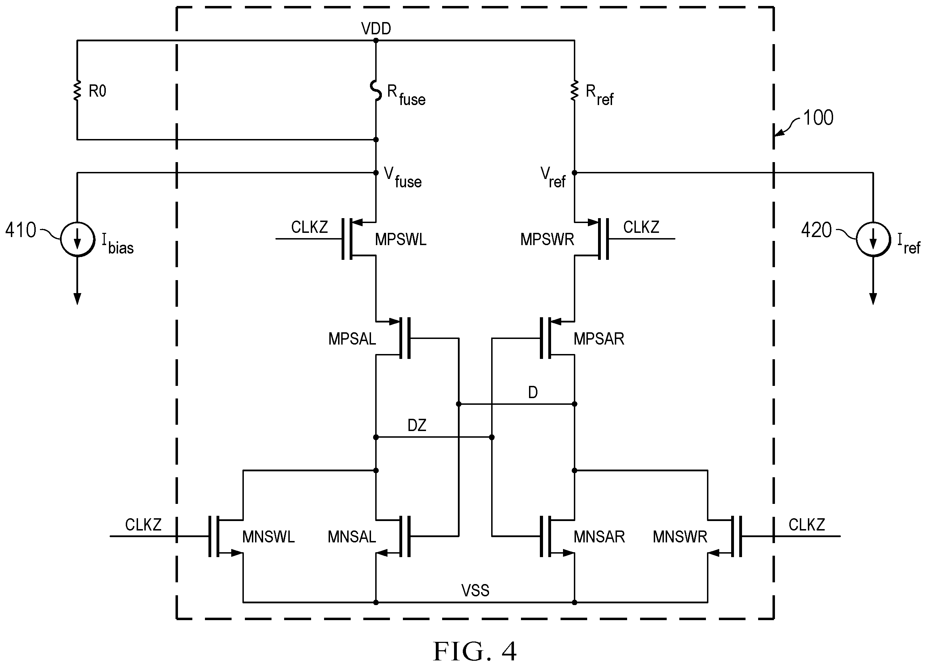

FIG. 4 illustrates the memory cell 100 in an example in which a first bias current sink 410 is connected to the fuse 120 and a second bias current sink 420 is connected to R_{ref}. This configuration may be used to test the operating margin of the memory cell 100 after programming the fuse 120. In an example, a minimum desired resistance of the fuse 120 after programming may be predetermined to be 50 kΩ. In the example that R_{ref} has a value of 25 kΩ, the second bias current sink 420 may be configured to sink through R_{ref} a bias current I_{ref} that is two times (50 kΩ/25 kΩ) a bias current I_{bias} drawn by the first bias current sink 410. This configuration may be used to test the operating margin of the memory cell 100 after programming the fuse 120. In another example, the minimum desired resistance of the fuse 120 after programming may be predetermined to be 100 kΩ, in which case I_{ref} may be four times I_{bias}. The configuration of I_{ref} as a multiple of I_{bias} allows R_{ref} to be made smaller than the minimum desired resistance of the fuse in the programmed state, reducing the die area needed to implement R_{ref}. As R_{ref} is made smaller, I_{ref} may be increased to produce the desired voltage drop across R_{ref}, increasing the size of the components implementing the current sink 420 and/or interconnections to R_{ref}, or even risking damaging R_{ref}. Thus in various examples a minimum ratio of I_{ref} to I_{bias} may be 2 to limit the size of such components.

When the CLK is unasserted and the current sinks 410, 420 are operated, a voltage V_{fuse} is produced at the node between the fuse 120 and the transistor MPSWL. Similarly, a voltage V_{ref} is produced at the node between R_{ref} and the transistor MPSWR. Under example conditions in which R_{ref} has a value of 25 kΩ and I_{ref}=4*I_{fuse}, if V_{fuse}<V_{ref} then R_{fuse} can be inferred to be greater than 100 kΩ. Conversely, if V_{fuse}>V_{ref} then R_{fuse} can be inferred to be less than the predetermined minimum of 100 kΩ. In response to this condition, which may fail to meet a desired margin specification, the IC in which the memory cell 100 is implemented may be scrapped.

The described principle can be generalized such that the second bias current sink 420 is configured such that to I_{ref} is *n* times greater than I_{bias}. V_{fuse} will equal V_{ref} when R_{fuse}=*n**R_{ref}, or *n*25* kΩ in the case that R_{ref}=25 kΩ. Furthermore, in general the ratio I_{ref}/I_{bias} need not be an integer value.

The current sinks 410, 420 may be provided by current sinks that are integrated into the IC, or may be provided external to the IC, such as in a multi-probe test configuration. When integrated into the IC, the current sinks 410, 420 provide the ability to determine if the resistance of the fuse 120 meets the predetermined operating margin independently of an external tester, including after deployment in an electronic system. On the other hand, if one or both of the current sinks 410, 420 are provided externally, then I_{bias} and/or I_{ref} may be varied as desired to determine an arbitrary operating margin ratio, and multiple test measurements may be performed, e.g. to determine the actual value of R_{fuse}.

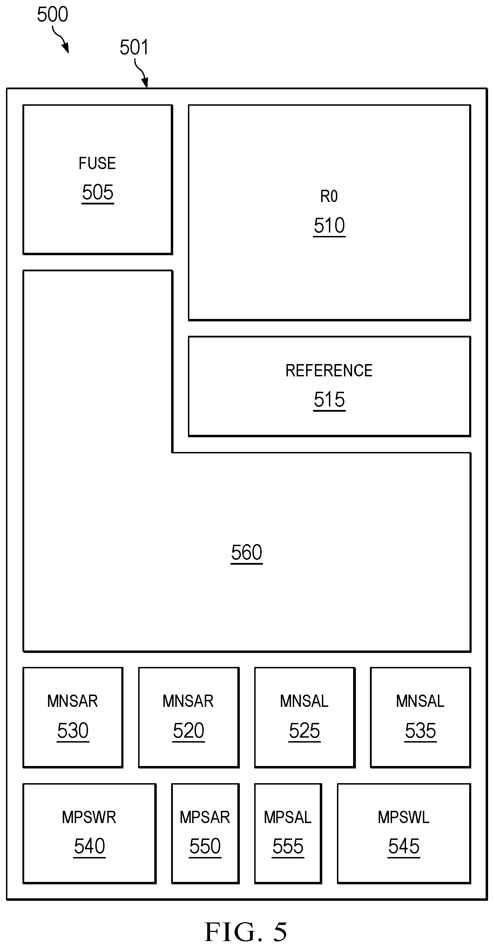

FIG. 5 illustrates a memory cell 500 as implemented on a silicon substrate 501 in various examples. Various designations of features of the memory cell 500 may correspond to features previously described. The memory cell 500 includes a fuse structure 505 and a shunt resistor 510, respectively exemplified by the fuse 120 and the shunt resistor R0 of FIG. 2. A reference resistor 515, exemplified by the resistor R_{ref} of FIG. 2, is located below the shunt resistor 510. The fuse structure 505 may be formed at least in part in a polysilicon layer or a metal interconnect layer over the substrate 501. The resistors 510, 515 may be formed in a polysilicon layer over the substrate 501, or in a diffusion region extending into the substrate 501. Transistors 520 and 525 exemplify the transistors MNSAR and MNSAL of FIG. 2; transistors 530 and 535 exemplify the transistors MNSAR and MNSAL of FIG. 2; transistors 540 and 545 exemplify the transistors MPSWR and MPSWL of FIG. 2; and transistors 550 and 555 exemplify the transistors MPSAR and MPSAL of FIG. 2. Each of the transistors 520, 525, 530, 535, 540, 545, 550 and 555 may be formed over and extending into the substrate 501 by any current or future-discovered methods. In various examples, Transistors 520 and 525 are matched, transistors 530 and 535 are matched, transistors 540 and 545 are matched, and/or transistors 550 and 555 are matched. Logic functions 560 related to other operating characteristics of the memory cell 500 are located between the fuse structure 505 and resistors 510, 515 and the transistors 520...555.

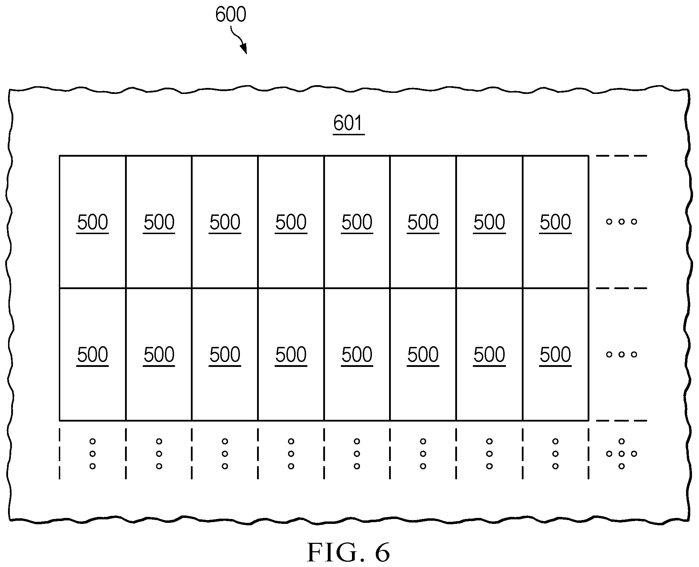

FIG. 6 illustrates an array 600 of the memory cells 500 as may be formed in an integrated circuit. Any number of the memory cells 500 may be formed over and extending into a semiconductor substrate 601. In the illustrated example, a number, e.g. 16, of the memory cells 500 are formed as a two-dimensional array. In other examples, an array of the memory cells 500 may be one-dimensional, or may be located arbitrarily within an integrated circuit design.

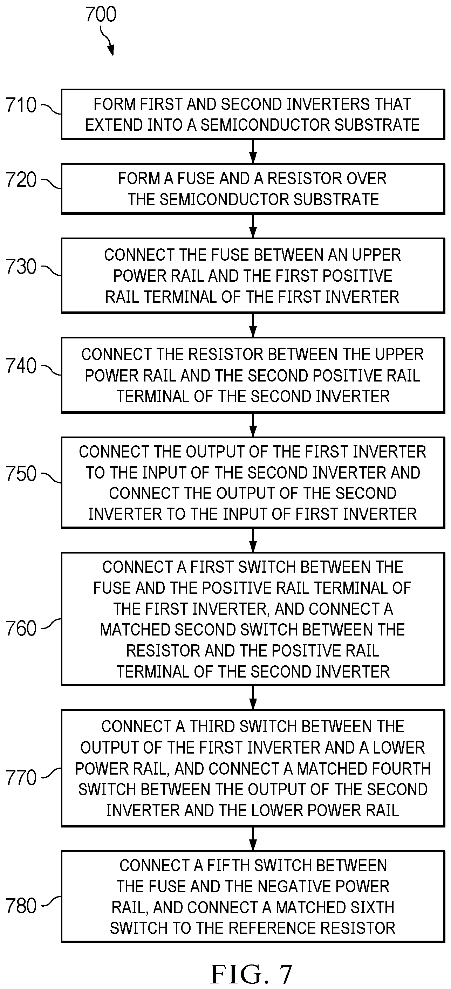

FIG. 7 describes a method 700 of forming an integrated circuit as described in the present disclosure. In a step 710 first and second inverters are formed extending into a semiconductor substrate. The first inverter has a first positive power terminal, a first output at a first output node, and a first input node. The second inverter has a second positive power terminal, a second output at a second output node, and a second input node.

In a step 720 a fuse and a resistor are formed over the semiconductor substrate.

In a step 730 the fuse is connected between an upper power rail and the first positive power terminal of the first inverter.

In a step 740 the resistor is connected between the upper power rail and the second positive power terminal of the second inverter.

In a step 750 the output node of the first inverter is connected to the input node of the second inverter and the output node of the second inverter is connected to the input node of first inverter.

In a step 760 a first switch is connected between the fuse and the positive power terminal of the first inverter, and a second switch is connected between the resistor and the positive power terminal of the second inverter.

In a step 770 a third switch is connected between the output node of the first inverter and a lower power rail, and a fourth switch is connected between the output node of the second inverter and the lower power rail. The first and second switches are configured to provide low resistance during a first phase of a control signal, and the third and fourth switches are configured to provide low resistance during a second phase of the control signal.

In a step 780 a fifth switch is connected between the fuse and the negative power rail, and a sixth switch is connected to the reference resistor. The fifth switch is configured to provide low resistance in response to a programming signal.

While various embodiments of the present disclosure have been described above, it should be understood that they have been presented by way of example only and not limitation. Numerous changes to the disclosed embodiments can be made in accordance with the disclosure herein without departing from the spirit or scope of the disclosure. Thus, the breadth and scope of the present invention should not be limited by any of the above described embodiments. Rather, the scope of the disclosure should be defined in accordance with the following claims and their equivalents.

## Claims

1. An integrated circuit, comprising:
a sense amplifier (105) including:
a first inverter (110) having a first positive power terminal, a first input and a first output; and
a second inverter (115) having a second positive power terminal, a second input connected to the first output and a second output connected to the first input;
a reference resistor connected between a positive voltage rail and the second positive power terminal;
a fuse (120) connected between the positive voltage rail and the first positive power terminal; and **characterized in that**
a first current sink connected to the first positive power terminal and a second current sink connected to the second positive power terminal, wherein the first current sink is configured produce a first current, and the second current sink is configured produce a second current at least two times the first current.

2. The integrated circuit of Claim 1, further comprising a programming transistor connected to the fuse (120) and a dummy transistor connected to the reference resistor.

3. The integrated circuit of Claim 1, further comprising a shunt resistor connected in parallel with the fuse (120).

4. The integrated circuit of Claim 1, further comprising a first switch transistor connected between the fuse (120) and the first positive power terminal, and a second switch transistor connected between the reference resistor and the second positive power terminal.

5. The integrated circuit of Claim 4, further comprising a third switch transistor connected between the first output and a lower voltage rail, and a fourth switch transistor connected between the second output and the lower voltage rail.

6. The integrated circuit of Claim 1, wherein the first output is configured to settle to a FALSE state and the second output is configured to settle to a TRUE state on the condition that the resistance of the fuse (120) is greater than the resistance of the reference resistor.

7. The integrated circuit of Claim 1, wherein the fuse (120) is a polysilicon fuse.

8. A method of forming an integrated circuit, comprising:
forming first and second inverters (110, 115) that extend into a semiconductor substrate;
forming a fuse (120) and a resistor over the semiconductor substrate;
connecting the fuse (120) between an upper power rail and a positive power terminal of the first inverter (110);
connecting the resistor between the upper power rail and a positive power terminal of the second inverter (115); and
connecting an output of the first inverter (110) to an input of the second inverter (115), and an output of the second inverter (115) to an input of the first inverter (110); and **characterized by**
connecting to the positive power terminal of the first inverter a first current sink configured to produce a first current and connecting to the positive power terminal of the second inverter a second current sink configured produce a second current that is at least two times the first current.

9. The method of Claim 8, further comprising connecting a shunt resistor in parallel with the fuse (120) between the positive power terminal of the first inverter (110).

10. The method of Claim 8, further comprising connecting a first transistor between the fuse (120) and the positive power terminal of the first inverter (110), and connecting a second transistor between the resistor and the positive power terminal of the second inverter (115).

11. The method of Claim 10, wherein the output of the second inverter (115) is configured to settle to a TRUE state on the condition that the first and second transistors are in a low-resistance state and the resistance of the fuse (120) is greater than the resistance of the resistor.

12. The method of Claim 8, wherein the first and second inverters (110, 115) are each implemented by a respective PMOS transistor and a respective NMOS transistor.

13. The method of Claim 8, wherein the fuse (120) is a polysilicon fuse.

14. The method of Claim 8, further comprising connecting a programming transistor to the fuse (120).

15. The method of Claim 14, further comprising connecting a dummy transistor to the resistor, the dummy transistor matched to the programming transistor.

## Patentansprüche

1. Integrierte Schaltung, die Folgendes umfasst:
einen Erfassungsverstärker (105), der Folgendes beinhaltet:
einen ersten Inverter (110) mit einem ersten positiven Leistungsanschluss, einem ersten Eingang und einem ersten Ausgang; und
einen zweiten Inverter (115) mit einem zweiten positiven Leistungsanschluss, einem zweiten Eingang, der mit dem ersten Ausgang verbunden ist, und einem zweiten Ausgang, der mit dem ersten Eingang verbunden ist;
einen Referenzwiderstand, der zwischen eine positive Spannungsschiene und den zweiten positiven Leistungsanschluss geschaltet ist;
eine Sicherung (120), die zwischen die positive Spannungsschiene und den ersten positiven Leistungsanschluss geschaltet ist; und **dadurch gekennzeichnet, dass**
eine erste Stromsenke mit dem ersten positiven Leistungsanschluss verbunden ist und eine zweite Stromsenke mit dem zweiten positiven Leistungsanschluss verbunden ist,
wobei die erste Stromsenke dazu ausgelegt ist, einen ersten Strom zu erzeugen, und die zweite Stromsenke dazu ausgelegt ist, einen zweiten Strom zu erzeugen, der mindestens das Zweifache des ersten Stroms beträgt.

2. Integrierte Schaltung nach Anspruch 1, ferner umfassend einen Programmiertransistor, der mit der Sicherung (120) verbunden ist, und einen Dummy-Transistor, der mit dem Referenzwiderstand verbunden ist.

3. Integrierte Schaltung nach Anspruch 1, ferner umfassend einen Shunt-Widerstand, der mit der Sicherung (120) parallel geschaltet ist.

4. Integrierte Schaltung nach Anspruch 1, ferner umfassend einen ersten Schalttransistor, der zwischen die Sicherung (120) und den ersten positiven Leistungsanschluss geschaltet ist, und einen zweiten Schalttransistor, der zwischen den Referenzwiderstand und den zweiten positiven Leistungsanschluss geschaltet ist.

5. Integrierte Schaltung nach Anspruch 4, ferner umfassend einen dritten Schalttransistor, der zwischen den ersten Ausgang und eine untere Spannungsschiene geschaltet ist, und einen vierten Schalttransistor, der zwischen den zweiten Ausgang und die untere Spannungsschiene geschaltet ist.

6. Integrierte Schaltung nach Anspruch 1, wobei der erste Ausgang dazu ausgelegt ist, in einen UNWAHR-Zustand einzuschwingen, und der zweite Ausgang dazu ausgelegt ist, in einen WAHR-Zustand einzuschwingen, vorausgesetzt, dass der Widerstandswert der Sicherung (120) größer als der Widerstandswert des Referenzwiderstands ist.

7. Integrierte Schaltung nach Anspruch 1, wobei die Sicherung (120) eine Polysiliziumsicherung ist.

8. Verfahren zum Bilden einer integrierten Schaltung, das Folgendes umfasst:
Bilden eines ersten und eines zweiten Inverters (110, 115), die sich in ein Halbleitersubstrat erstrecken;
Bilden einer Sicherung (120) und eines Widerstands über dem Halbleitersubstrat;
Verbinden der Sicherung (120) zwischen einer oberen Leistungsschiene und einem positiven Leistungsanschluss des ersten Wechselrichters (110);
Verbinden des Widerstands zwischen der oberen Leistungsschiene und einem positiven Leistungsanschluss des zweiten Wechselrichters (115); und
Verbinden eines Ausgangs des ersten Inverters (110) mit einem Eingang des zweiten Inverters (115) und eines Ausgangs des zweiten Inverters (115) mit einem Eingang des ersten Inverters (110); und **gekennzeichnet durch**
Verbinden, mit dem positiven Leistungsanschluss des ersten Inverters, einer ersten Stromsenke, die dazu ausgelegt ist, einen ersten Strom zu erzeugen, und Verbinden, mit dem positiven Leistungsanschluss des zweiten Inverters,
einer zweiten Stromsenke, die dazu ausgelegt ist, einen zweiten Strom zu erzeugen, der mindestens das Zweifache des ersten Stroms beträgt.

9. Verfahren nach Anspruch 8, ferner umfassend Verbinden eines Shunt-Widerstands in Parallelschaltung mit der Sicherung (120) zwischen dem positiven Leistungsanschluss des ersten Inverters (110).

10. Verfahren nach Anspruch 8, ferner umfassend Verbinden eines ersten Transistors zwischen der Sicherung (120) und dem positiven Leistungsanschluss des ersten Inverters (110) und Verbinden eines zweiten Transistors zwischen dem Widerstand und dem positiven Leistungsanschluss des zweiten Inverters (115).

11. Verfahren nach Anspruch 10, wobei der Ausgang des zweiten Inverters (115) dazu ausgelegt ist, in einen WAHR-Zustand einzuschwingen, vorausgesetzt, dass sich der erste und der zweite Transistor in einem Zustand mit niedrigem Widerstandswert befinden und der Widerstandswert der Sicherung (120) größer als der Widerstandswert des Widerstands ist.

12. Verfahren nach Anspruch 8, wobei der erste und der zweite Inverter (110, 115) jeweils durch einen jeweiligen PMOS-Transistor und einen jeweiligen NMOS-Transistor implementiert werden.

13. Verfahren nach Anspruch 8, wobei die Sicherung (120) eine Polysiliziumsicherung ist.

14. Verfahren nach Anspruch 8, ferner umfassend Verbinden eines Programmiertransistors mit der Sicherung (120).

15. Verfahren nach Anspruch 14, ferner umfassend Verbinden eines Dummy-Transistors mit dem Widerstand, wobei der Dummy-Transistor an den Programmiertransistor angeglichen ist.

## Revendications

1. Circuit intégré, comprenant :
un amplificateur de lecture (105) comportant :
un premier inverseur (110) ayant une première borne de puissance positive, une première entrée et une première sortie ; et
un deuxième inverseur (115) ayant une deuxième borne de puissance positive, une deuxième entrée connectée à la première sortie et une deuxième sortie connectée à la première entrée ;
une résistance de référence connectée entre un rail de tension positive et la deuxième borne de puissance positive ;
un fusible (120) connecté entre le rail de tension positive et la première borne de puissance positive ; et **caractérisé en ce que**
un premier puits de courant est connecté à la première borne de puissance positive et un deuxième puits de courant est connecté à la deuxième borne de puissance positive,
le premier puits de courant étant configuré pour produire un premier courant, et le deuxième puits de courant étant configuré pour produire un deuxième courant d'au moins deux fois le premier courant.

2. Circuit intégré selon la revendication 1, comprenant en outre un transistor de programmation connecté au fusible (120) et un transistor fictif connecté à la résistance de référence.

3. Circuit intégré selon la revendication 1, comprenant en outre une résistance shunt connectée en parallèle avec le fusible (120).

4. Circuit intégré selon la revendication 1, comprenant en outre un premier transistor de commutation connecté entre le fusible (120) et la première borne de puissance positive, et un deuxième transistor de commutation connecté entre la résistance de référence et la deuxième borne de puissance positive.

5. Circuit intégré selon la revendication 4, comprenant en outre un troisième transistor de commutation connecté entre la première sortie et un rail de tension basse, et un quatrième transistor de commutation connecté entre la deuxième sortie et le rail de tension basse.

6. Circuit intégré selon la revendication 1, dans lequel la première sortie est configurée pour s'établir à un état FAUX et la deuxième sortie est configurée pour s'établir à un état VRAI à la condition que la valeur de résistance du fusible (120) soit supérieure à la valeur de résistance de la résistance de référence.

7. Circuit intégré selon la revendication 1, dans lequel le fusible (120) est un fusible en polysilicium.

8. Procédé de formation d'un circuit intégré, comprenant :
la formation de premier et deuxième inverseurs (110, 115) s'étendant dans un substrat semi-conducteur ;
la formation d'un fusible (120) et d'une résistance sur le substrat semi-conducteur ;
la connexion du fusible (120) entre un rail de puissance haute et une borne de puissance positive du premier inverseur (110) ;
la connexion de la résistance entre le rail de puissance haute et une borne de puissance positive du deuxième inverseur (115) ; et
la connexion d'une sortie du premier inverseur (110) à une entrée du deuxième inverseur (115), et une sortie du deuxième inverseur (115) à une entrée du premier inverseur (110) ; et **caractérisé par**
la connexion à la borne de puissance positive du premier inverseur d'un premier puits de courant configuré pour produire un premier courant et la connexion à la borne de puissance positive du deuxième inverseur d'un deuxième puits de courant configuré pour produire un deuxième courant qui est d'au moins deux fois le premier courant.

9. Procédé selon la revendication 8, comprenant en outre la connexion d'une résistance shunt en parallèle avec le fusible (120) entre la borne de puissance positive du premier inverseur (110).

10. Procédé selon la revendication 8, comprenant en outre la connexion d'un premier transistor entre le fusible (120) et la borne d'alimentation positive du premier inverseur (110), et la connexion d'un deuxième transistor entre la résistance et la borne d'alimentation positive du deuxième inverseur (115).

11. Procédé selon la revendication 10, dans lequel la sortie du deuxième inverseur (115) est configurée pour s'établir à un état VRAI à la condition que les premier et deuxième transistors soient dans un état de faible résistance et que la valeur de résistance du fusible (120) soit supérieure à la valeur de résistance de la résistance.

12. Procédé selon la revendication 8, dans lequel les premier et deuxième inverseurs (110, 115) sont chacun mis en œuvre par un transistor PMOS respectif et un transistor NMOS respectif.

13. Procédé selon la revendication 8, dans lequel le fusible (120) est un fusible en polysilicium.

14. Procédé selon la revendication 8, comprenant en outre la connexion d'un transistor de programmation au fusible (120).

15. Procédé selon la revendication 14, comprenant en outre la connexion d'un transistor fictif à la résistance, le transistor fictif étant apparié au transistor de programmation.
